# EUROPEAN PATENT APPLICATION

(11) **EP 2 124 262 A2**
(43) Date of publication of application: **25.11.2009**
(21) Application number: 09154160.7
(22) Date of filing: 02.03.2009
(51) Int. Cl.: H01L 31/048, H01L 31/052

(54) **Layer arrangement being thermally conductive and electrically isolating**

(30) Priority: 14.03.2008 US 36506 P; 12.02.2009 US 369771
(71) Applicant: E. I. du Pont de Nemours and Company, Wilmington, DE 19898 (US)
(72) Inventor: Auman, Brian, C., Pickerington, OH 43147 (US); Haeger, Carl, Reynoldsburg, OH 43068 (US); Lacourt, Philip Roland, Chillicothe, OH 45601 (US); Mcalees, Mark Elliott, Circleville, OH 43113 (US); Meritt, Stanley Duane, Bear, DE 19701 (US); Prejean, George Wyatt, Orange, TX 77632 (US); Tate, Harland Lee, Golden, CO 80401 (US)
(74) Representative: Towler, Philip Dean

(57) **Abstract**

The present disclosure relates to a device for thermally cooling while electrically insulating. The device contains a first adhesive layer, polyimide substrate, a second adhesive layer and a heat sink. The first adhesive layer and the second adhesive layer are a vinyl or acrylic polymer. The polyimide substrate has at least two polyimide layers. The polyimide layers are derived from at least one aromatic dianhydride and at least one aromatic diamine. The adhesive layers and the polyimide layers may contain thermally conductive fillers, light absorbing pigments or mixtures of both.

## Description

### FIELD OF DISCLOSURE

The present disclosure relates generally to multilayer device for thermal dissipation and electrical insulation. More specifically, the device comprises a filled polyimide film that can be bonded to a metal heat sink on one side and to an electronic component on the other, thereby electrically insulating the electronic component while also conducting heat away from the circuit.

### BACKGROUND OF THE DISCLOSURE

In the field of electronic components, including photovoltaic cells, both heat dissipation and electrical insulation are becoming increasingly important. Integrated circuits are increasingly being manufactured at smaller feature dimensions and higher densities, resulting in an increased need for thermal dissipation and electrical insulation. Similarly, thermal dissipation and electrical insulation are also important for photovoltaic systems, which tend to require a highly (electrically) insulated environment for collecting and distributing electrical current and also tend to lose operational efficiency with increasing temperature.

US 5,691,567 to Lo, et al., describes a polyimide tape used to connect a heat sink to a lead frame by means of a die attach adhesive. Such a polyimide tape system is described in the background discussion in Lo, and Lo then teaches against such a polyimide tape system.

A need exists for a device that: i. provides acceptable bond strength under elevated temperatures and humidity; ii. has acceptable electrical insulation properties; iii. can withstand relatively high voltages, iv. resists degradation due to light; and v. also has acceptable thermal conductivity.

### SUMMARY

The present disclosure is directed to a device for thermally cooling while electrically insulating. The device contains a first adhesive layer, polyimide substrate, a second adhesive layer and a heat sink. The first adhesive layer and the second adhesive layer have 68 to 98 weight percent vinyl or acrylic polymer. The polyimide substrate has at least two polyimide layers having 40 to 90 weight percent polyimide where the polyimide is derived from at least one aromatic dianhydride and at least one aromatic diamine.

### DETAILED DESCRIPTION OF THE PREFERRED EMBODIMENT(S)

The present disclosure is directed to a device for thermally cooling while electrically insulating. In one embodiment, the device has
i. a first adhesive layer having a top surface and a bottom surface. The first adhesive layer bottom surface being directly bonded to a polyimide substrate,
ii. a polyimide substrate having at least a first polyimide layer and a second polyimide layer where the first polyimide layer and the second polyimide layer are directly bonded to each other.
iii. a second adhesive layer having a top surface and a bottom surface. The second adhesive layer top surface being directly bonded to the polyimide substrate.
iv. a metal heat sink having a top surface and a bottom surface, the heat sink top surface being directly bonded to the second adhesive layer bottom surface.

The device is well suited for cooling and insulating electrical components. The term "electrical components" herein denotes but is not limited to integrated circuit devices plus other active and passive components like resistors, capacitors, inductors, transistors, diodes, and photovoltaic cells. The device of the present disclosure is particularly well suited for photovoltaic cells that utilize a light concentrator. In some embodiments, the semiconducting layer of a photovoltaic cell is directly bonded to the first adhesive layer top surface. The term "bonded", "bonding" or any other variation thereof is synonymous with "adhered" or "adhesion" and the terms may be used interchangeably. The devices of the present disclosure tend to: i. maintain good bond strength under high temperatures, ii. provide useful electrical insulation, iii. provide high voltage resistance, iv. provide useful resistance to degradation under exposure to light, and v. provide excellent thermal conductivity.

### Adhesive layers

The present disclosure comprises a first adhesive layer and a second adhesive layer. In some embodiments, the first adhesive layer and second adhesive layer are the same material. In some embodiments, they are different materials. The first adhesive layer and the second adhesive layer have an amount between (and optionally including) any two of the following weight percentages of vinyl or acrylic polymer: 68, 70, 72, 74, 76, 78, 80, 82, 84, 86, 88, 90, 92, 94, 96 and 98 weight percent (vinyl or acrylic polymer). In some embodiments, the adhesive polymer is crosslinkable. In another embodiment, the adhesive polymer is extrudable or coatable. In some embodiments, the first and second adhesive layers are selected from a group consisting of:
ethylene vinyl acetate copolymer with adhesion promoter,
ethylene vinyl acetate glycidyl acrylate terpolymer,
ethylene vinyl acetate glycidyl methacrylate terpolymer,
ethylene alkyl acrylate copolymers with adhesion promoter,
ethylene alkyl methacrylate copolymers with adhesion promoter,
ethylene glycidyl acrylate,
ethylene glycidyl methacrylate,
ethylene alkyl acrylate glycidyl acrylate terpolymer,
ethylene alkyl methacrylate glycidyl acrylate terpolymer,
ethylene alkyl acrylate maleic anhydride terpolymers,
ethylene alkyl methacrylate maleic anhydride terpolymers
ethylene alkyl acrylate glycidyl methacrylate terpolymers,
ethylene alkyl methacrylate glycidyl methacrylate terpolymers,
alkyl acrylate acrylonitrile acrylic acid terpolymers including salts thereof,
alkyl acrylate acrylonitrile methacrylic acid terpolymers including salts thereof,
ethylene acrylic acid copolymer including salts thereof,
ethylene methacrylic acid copolymer including salts thereof,
alkyl acrylate acrylonitrile glycidyl methacrylate terpolymers,
alkyl methacrylate acrylonitrile glycidyl methacrylate terpolymers,
alkyl acrylate acrylonitrile glycidyl acrylate terpolymers,
alkyl methacrylate acrylonitrile glycidyl acrylate terpolymers,
polyvinyl butyral,
ethylene alkyl acrylate methacrylic acid terpolymers including salts thereof,
ethylene alkyl methacrylate methacrylic acid terpolymers including salts thereof,
ethylene alkyl acrylate acrylic acid terpolymers including salts thereof mixtures thereof,
ethylene alkyl methacrylate acrylic acid terpolymers including salts thereof,
ethylene ethyl hydrogen maleate,
ethylene alkyl acrylate ethyl hydrogen maleate,
ethylene alkyl methacrylate ethyl hydrogen maleate,
and mixtures thereof.

There is a practical limit to the thickness of the adhesive layers. The adhesive layers should be thin enough to not adversely impact thermal dissipation, thus allowing heat to pass efficiently to the heat sink. Adhesive layers should also provide reliable bonding between the polyimide substrate and the heat sink, as well as any electrical component to which the first adhesive top layer is bonded, at elevated temperatures and humidity. In some embodiments, the first adhesive layer and the second adhesive layer thickness are each between (and optionally including) any two of the following thicknesses: 6.25, 7, 8, 9, 10, 15, 20, 25, 30, 35, 40, 45, 50, 55, 60, 65, 70 and 75 microns. In some embodiments, the adhesive layers provide bond strength of at least 370 g/cm and preferably higher than 740 g/cm. The bond strength should also be maintained at a level of at least 370 g/cm over the life of the component under conditions of elevated temperature and humidity. These conditions will depend on the particular component and the application in which it is used.

In some embodiments, the first adhesive layer and the second adhesive layer additionally comprise a filler selected from thermally conductive filler, light absorbing pigment and mixtures thereof. In some embodiments, the first adhesive layer and the second adhesive layer contain the same thermally conductive fillers or light absorbing pigments or mixtures thereof. In another embodiment, the first adhesive layer and the second adhesive layer contain different thermally conductive fillers or light absorbing pigments or mixtures thereof. In yet another embodiment, the thermally conductive filler and the light absorbing pigment may be the same material when the material can perform both functions.

In some embodiments, the adhesive layers may include additional additives such as, antioxidants, crosslinking agents, adhesion promoters and other common additives known in the art. In some embodiments, an organo functional silane adhesion promoter is used. In another embodiment, an alkyl titanate adhesion promoter is used.

The adhesive layers of the present disclosure have an advantage over pressure sensitive adhesives used in the prior art. The adhesive layers of the present disclosure will have better heat resistance and cohesive strength. In addition, the adhesive layers of the present disclosure are integrated films, thus are more suitable for a continuous manufacturing process.

### Polyimide substrate

The polyimide substrates of the present disclosure provide an electrically insulating layer to prevent undesired electrical communication between an electrical component and the heat sink. The polyimide substrate of the present disclosure allows high electrical insulation at high voltages, resists degradation under exposure to light and provides acceptable thermal conduction, generally allowing an electronic component to operate at desired temperatures. This is particularly true when the electrical component is a photovoltaic cell utilizing a light concentrator. Temperatures can reach several hundreds degrees centigrade at peak operating conditions under highly concentrated light. High voltages, according to the present disclosure, are voltages in excess of 1000 volts DC or in some applications, greater than 2000 volts DC.

The polyimide substrate of the present disclosure has at least two polyimide layers, a first polyimide layer and a second polyimide layer. In some embodiments, the first polyimide layer and the second polyimide layer are directly bonded to each other. In some embodiments, the first polyimide layer and the second polyimide layer are the same polyimide or different. The polyimide layers provide thermal conduction and electrical insulation properties. The first polyimide layer and the second polyimide layer each comprise an amount between (and optionally including) any two of the following weight percentages of polyimide: 40, 45, 50, 55, 60, 65, 70, 75, 80, 85 and 90 weight percent polyimide. The polyimide is derived from at least one aromatic dianhydride and at least one aromatic diamine, the aromatic diamine being at least 80 mole percent of the total moles of diamine incorporated into the polyimide and the aromatic dianhydride being at least 80 mole percent of the total moles of dianhydride incorporated into the polyimide. In some embodiments, the polyimide is a wholly aromatic polyimide. In some embodiments, the polyimide layers may be corona treated to aid in bonding.

In some embodiments, the aromatic dianhydride polyimide precursor of the present disclosure is selected from a group consisting of
1. pyromellitic dianhydride (PMDA);
2. 3,3',4,4'-biphenyl tetracarboxylic dianhydride (BPDA);
3. 3,3',4,4'-benzophenone tetracarboxylic dianhydride (BTDA);
4. 4,4'-oxydiphthalic anhydride (ODPA);
5. 3,3',4,4'-diphenylsulfone tetracarboxylic dianhydride (DSDA);
6. 2,2-bis(3,4-dicarboxyphenyl) 1,1,1,3,3,3-hexafluoropropane dianhydride (6FDA);
7. 4,4'-(4,4'-isopropylidenediphenoxy)bis(phthalic anhydride) (BPADA);
8. 2,3,6,7-naphthalene tetracarboxylic dianhydride;
9. 1,2,5,6-naphthalene tetracarboxylic dianhydride;
10. 1,4,5,8-naphthalene tetracarboxylic dianhydride;
11. 2,6-dichloronaphthalene-1,4,5,8-tetracarboxylic dianhydride;
12. 2,7-dichloronaphthalene-1,4,5,8-tetracarboxylic dianhydride;
13. 2,3,3',4'-biphenyl tetracarboxylic dianhydride;
14. 2,2',3,3'-biphenyl tetracarboxylic dianhydride;
15. 2,3,3',4'-benzophenone tetracarboxylic dianhydride;
16. 2,2',3,3'-benzophenone tetracarboxylic dianhydride;
17. 2,2-bis(3,4-dicarboxyphenyl) propane dianhydride;
18. 1,1-bis(2,3-dicarboxyphenyl) ethane dianhydride;
19. 1,1-bis(3,4-dicarboxyphenyl) ethane dianhydride;
20. bis-(2,3-dicarboxyphenyl) methane dianhydride;
21. bis-(3,4-dicarboxyphenyl) methane dianhydride;
22. 4,4'-(hexafluoroisopropylidene) diphthalic anhydride;
23. bis-(3,4-dicarboxyphenyl) sulfoxide dianhydride;
24. tetrahydrofuran-2,3,4,5-tetracarboxylic dianhydride;
25. pyrazine-2,3,5,6-tetracarboxylic dianhydride;
26. thiophene-2,3,4,5-tetracarboxylic dianhydride;
27. phenanthrene-1,8,9,10-tetracarboxylic dianhydride;
28. perylene-3,4,9,10-tetracarboxylic dianhydride;
29. bis-1,3-isobenzofurandione;
30. bis-(3,4-dicarboxyphenyl) thioether dianhydride;
31. bicyclo[2,2,2]oct-7-ene-2,3,5,6-tetracarboxylicdianhydride;
32. 2-(3',4'-dicarboxyphenyl) 5,6-dicarboxybenzimidazole dianhydride;
33. 2-(3',4'-dicarboxyphenyl) 5,6-dicarboxybenzoxazole dianhydride;
34. 2-(3',4'-dicarboxyphenyl) 5,6-dicarboxybenzothiazole dianhydride;
35. bis-(3,4-dicarboxyphenyl) 2,5-oxadiazole 1,3,4-dianhydride;
36. bis-2,5-(3',4'-dicarboxydiphenylether) 1,3,4-oxadiazole dianhydride;
37.bis-2,5-(3',4'-dicarboxydiphenylether) 1,3,4-oxadiazole dianhydride;
38.5-(2,5-dioxotetrahydro)-3-methyl-3-cyclohexene-1,2-dicarboxylic anhydride;
39. trimellitic anhydride 2,2-bis(3',4'-dicarboxyphenyl)propane dianhydride;
40. 1,2,3,4-cyclobutane dianhydride;
41. 2,3,5-tricarboxycyclopentylacetic acid dianhydride;
and mixtures thereof.

In some embodiments, the aromatic diamine of the present disclosure is selected from a group consisting of
1. 4,4'-diaminodiphenyl ether (4,4'-ODA);
2. 3,4'-diaminodiphenyl ether (3,4'-ODA);
3. 1,3-bis- (4-aminophenoxy) benzene (APB-134 or RODA);
4. 1,3-bis- (3-aminophenoxy) benzene (APB-133);
5. 1,2-diaminobenzene (OPD);
6. 1,3-diaminobenzene (MPD);
7. 1,4-diaminobenzene (PPD);
8. 2,2 bis-(4-aminophenyl) propane;
9. 4,4'-diaminodiphenyl methane;
10. 4,4'-diaminodiphenyl sulfide (4,4'-DDS);
11. 3,3'-diaminodiphenyl sulfone (3,3'-DDS);
12. 4,4'-diaminodiphenyl sulfone;
13. 1,2-bis- (4-aminophenoxy) benzene;
14. 1,2-bis- (3-aminophenoxy) benzene;
15. 1,4-bis-(4-aminophenoxy) benzene;
16. 1,4-bis-(3-aminophenoxy) benzene;
17. 1,5-diaminonaphthalene;
18. 1,8-diaminonaphthalene;
19. 2,2'-bis(trifluoromethyl)benzidine;
20. 4,4'-diaminodiphenyldiethylsilane;
21. 4,4'-diaminodiphenylsilane;
22. 4,4'-diaminodiphenylethylphosphine oxide;
23. 4,4'-diaminodiphenyl-N-methyl amine;
24. 4,4'-diaminodiphenyl-N-phenyl amine;
25. 2,5-dimethyl-1,4-diaminobenzene;
26. 2-(trifluoromethyl)-1,4-phenylenediamine;
27. 5-(trifluoromethyl)-1,3-phenylenediamine;
28. 2,2-Bis[4-(4-aminophenoxy)phenyl]-hexafluoropropane (BDAF);
29. 2,2-bis(3-aminophenyl) 1,1,1,3,3,3-hexafluoropropane;
30. benzidine;
31. 4,4'-diaminobenzophenone;
32. 3,4'-diaminobenzophenone;
33. 3,3'-diaminobenzophenone;
34. m-xylylene diamine;
35. bisaminophenoxyphenylsulfone;
36. 4,4'-isopropylidenedianiline;
37. N,N-bis- (4-aminophenyl) methylamine;
38. N,N-bis- (4-aminophenyl) aniline
39. 3,3'-dimethyl-4,4'-diaminobiphenyl;
40. 4-aminophenyl-3-aminobenzoate;
41. 2,4-diaminotoluene;
42. 2,5-diaminotoluene;
43. 2,6-diaminotoluene;
44. 2,4-diamine-5-chlorotoluene;
45. 2,4-diamine-6-chlorotoluene;
46. 4-chloro-1,2-phenylenediamine;
47. 4-chloro-1,3-phenylenediamine;
48. 2,4-bis- (beta-amino-t-butyl) toluene;
49. bis-(p-beta-amino-t-butyl phenyl) ether;
50. p-bis-2- (2-methyl-4-aminopentyl) benzene;
51. 1-(4-aminophenoxy)-3-(3-aminophenoxy) benzene;
52. 1-(4-aminophenoxy)-4-(3-aminophenoxy) benzene;
53. 2,2-bis-[4-(4-aminophenoxy)phenyl] propane (BAPP);
54. bis-[4-(4-aminophenoxy)phenyl] sulfone (BAPS);
55. 2,2-bis[4-(3-aminophenoxy)phenyl] sulfone (m-BAPS);
56. 4,4'-bis-(aminophenoxy)biphenyl (BAPB);
57. bis-(4-[4-aminophenoxy]phenyl) ether (BAPE);
58. 2,2'-bis-(4-aminophenyl)-hexafluoropropane (6F diamine);
59. bis(3-aminophenyl)-3,5-di(trifluoromethyl)phenylphosphine oxide
60. 2,2'-bis-(4-phenoxy aniline) isopropylidene;
61. 2,4,6-trimethyl-1,3-diaminobenzene;
62. 4,4'-diamino-2,2'-trifluoromethyl diphenyloxide;
63. 3,3'-diamino-5,5'-trifluoromethyl diphenyloxide;
64. 4,4'-trifluoromethyl-2,2'-diaminobiphenyl;
65. 4,4'-oxy-bis-[(2-trifluoromethyl) benzene amine];
66. 4,4'-oxy-bis-[(3-trifluoromethyl) benzene amine];
67. 4,4'-thio-bis-[(2-trifluoromethyl) benzene-amine];
68. 4,4'-thiobis-[(3-trifluoromethyl) benzene amine];
69. 4,4'-sulfoxyl-bis-[(2-trifluoromethyl) benzene amine;
70. 4,4'-sulfoxyl-bis-[(3-trifluoromethyl) benzene amine];
71. 4,4'-keto-bis-[(2-trifluoromethyl) benzene amine];
72. 9,9-bis(4-aminophenyl)fluorene;
73. 1,3-diamino-2,4,5,6-tetrafluorobenzene;
74. 3,3'-bis(trifluoromethyl)benzidine;
and mixtures thereof.

Polyimides of the present disclosure can be made by methods well known in the art and their preparation need not be discussed here.

In some embodiments, the first polyimide layer and the second polyimide layer each further comprise an amount between (and optionally including) any two of the following weight percentages of thermally conductive filler: 10, 15, 20, 25, 30, 35, 40, 45 and 50 weight percent of a thermally conductive filler. The thermally conductive filler is added to increase the thermal conductivity of the polyimide substrate thus increasing efficiency of thermal transfer to the heat sink. The ability to efficiently dissipate heat from an electronic component, more specifically, a photovoltaic cell is important as it is known that the performance of photovoltaic materials decrease with elevated temperatures. In some embodiments, the thermally conductive filler in the polyimide substrate is the same as in the adhesive layers. In another embodiment, the thermally conductive filler may be different from the thermally conductive filler in the adhesive layers.

In some embodiments, the thermal conductivity of 25 micron polyimide films of the present disclosure is at least 0.24 watts/mK at 25 °C. In other embodiments, the thermal conductivity of the polyimide films of the present disclosure is at least 0.33 watts/mK at 25 °C. Xenon nano flash method was used to determine the thermal conductivity measurements of the present disclosure. The thermal conductivity of the polyimide films of the present disclosure can be as much as 54% greater, or even more than 108% greater than their unfilled counterparts. The term "thermal conductivity" herein denotes a measure of the ability of a material to transfer heat; given two surfaces on either side of the material with a temperature difference between them.

In some embodiments, the polyimide substrate's first polyimide layer and second polyimide layer each further comprise from 0, 5, 10, 15 and up to 20 weight percent light absorbing pigment. In some embodiments, the light absorbing pigment in the polyimide substrate is the same as the light absorbing pigment in the adhesive layers. In other embodiments, the light absorbing pigment in the polyimide substrate is the different than the light absorbing pigment in the adhesive layers.

In one embodiment, the polyimide substrate additionally comprises at least one fluoropolymer adhesive layer having a top layer and a bottom layer wherein the fluoropolymer adhesive top layer is attached to the first polyimide layer and the fluoropolymer adhesive bottom layer is attached to the second polyimide layer. In some embodiments, the fluoropolymer adhesive layer is selected from tetrafluoroethylene hexafluoropropylene copolymer (Teflon® FEP), tetrafluoroethylene perfluoroalkoxy copolymer (Teflon® PFA), tetrafluoroethylene ethylene copolymer (Tefzel®), polyvinyl fluoride (Tedlar®) and mixtures thereof.

In some embodiments, the fluoropolymer adhesive layer additionally comprises a thermally conductive filler. The thermally conductive filler in the fluoropolymer adhesive layer may be the same or different from the thermally conductive filler in the first adhesive layer, second adhesive layer or the polyimide substrate. In some embodiments, the fluoropolymer adhesive layer thickness is between (and optionally including) any two of the following thicknesses: 1.25, 2, 3, 4, 5, 6, 7, 8, 9, 10, 11, 12 and 12.5 microns.

In some embodiments, the polyimide substrate first polyimide layer and second polyimide layer comprise two or more additional polyimide layers. The additional polyimide layers may be the same or different from the first polyimide layer and the second polyimide layer. In some embodiments, the additional polyimide layers contain a thermally conductive filler, a light absorbing pigment and mixtures thereof. In another embodiment, only some of the additional polyimide layers contain a thermally conductive filler, a light absorbing pigment and mixtures thereof. In some embodiments, the thermally conductive filler and light absorbing pigment in the additional polyimide layers are the same or different from the thermally conductive filler and light absorbing pigment in the first polyimide layer and the second polyimide layer.

There is a practical limit to the thickness of the polyimide substrate. If the polyimide substrate is too thick, thermal dissipation of the device may be adversely affected. If the polyimide layers are too thin, dielectric breakdown may occur. The desired thickness of the polyimide substrate must balance dielectric properties as well as thermal conductivity. This balance will depend on the electrical application in which the device of the present disclosure is used, the voltage applied and the amount of heat generated. In some embodiments, the polyimide substrate thickness is between (and optionally including) any two of the following thicknesses: 12.5, 14, 16, 18, 20, 25, 30, 40, 50, 60, 70, 80, 90, 100, 110, 120 and 124 microns.

Having thin multiple polyimide layers has an advantage over a single polyimide layer of the same thickness. Multiple layers decrease the chance of having pinhole or other defects (foreign particles, gels, filler or other agglomerates) that could adversely impact the electrical integrity and electrical breakdown performance of a dielectric film. The term "pinhole" herein denotes a small hole that results from non-uniformities in a coating or preparation process. These defects can be a serious issue particularly in thin films in terms of electrical performance unless great care is taken to eliminate them. A single layer film can be made thicker in an attempt to decrease defects or their impact on the film's integrity; however, the use of too thick a film in the present disclosure may adversely impact the thermal dissipation of the device. A multilayer polyimide substrate having thin multiple layers would reduce the impact of pinholes and other defects and also maintain good thermal dissipation. Multiple polyimide layers can be prepared either by laminating single layers together with or without a separate adhesive or by coating of layer on top of one another or by coextrusion processes to prepare multilayer films, or by combinations of these. A description of a coextrusion process for preparing multilayer polyimide films is provided by EP0659553A1, Sutton et al., and is incorporated herein by reference. Utilization of multilayers of polyimide helps to greatly eliminate the occurrence of defects that may span the total thickness of the dielectric layer because the likelihood of defects that overlap in each of the individual layers is extremely small and therefore a defect in any one of the layers is much less likely to cause an electrical failure through the entire thickness of the dielectric.

The polyimide layers of the present disclosure have an advantage over Tefzel® (ethylene tetrafluoroethylene copolymer) layers commonly used in the prior art. Tefzel® has a dielectric strength of 4000V/mil. In some embodiments, polyimides of the present disclosure have a dielectric strength of at least 5400 V/mil. In some embodiments, polyimides of the present disclosure have a dielectric strength of at least 7400 V/mil. (values are for 1 mil film)

### Thermally conductive filler

The term "thermally conductive filler" as used herein refers to any filler having the ability to conduct heat. The filler can be any shape. In some embodiments, the thermally conductive filler can have an average particle size in a range between (and optionally including) any two of the following sizes: 0.5, 1,5,10, 20, 30, 40 50, 60, 70, 80, 90, 100, 125, 150, 175, 200, 250, 300, 350, 400, 450, 500 and 5,000 nanometers, where at least 80, 85, 90, 92, 94, 95, 96, 98, 99 or 100 percent of the dispersed filler is within the above size range(s). In some embodiments, the thermally conductive fillers can require milling and filtration to break up or remove unwanted particle agglomeration which can result in low dielectric strength.

In some embodiments, the thermally conductive filler is selected from a group consisting of aluminum oxide, boron nitride coated aluminum oxide, granular aluminum oxide, fumed aluminum oxide, silicon dioxide, granular silicon dioxide, fumed silicon dioxide, silicon carbide, aluminum nitride, aluminum oxide coated aluminum nitride, silicon dioxide coated aluminum nitride, titanium dioxide, boron nitride, cubic boron nitride, hexagonal boron nitride, diamond, beryllium oxide, talc, zinc oxide and mixtures thereof.

There is a practical limit to the amount of thermally conductive filler that can be added. If the amount of thermally conductive filler is too high then adhesion, electrical insulating ability and mechanical properties can be adversely affected.

### Light absorbing pigment

The term "light absorbing pigment" as used herein refers any additive that helps protect a polymer composition from the long-term degradation effects from light. In some embodiments, the light absorbing pigment is a UV absorber. In another embodiment, the light absorbing pigment is a UV stabilizer. In yet another embodiment, mixtures of UV absorbers and UV stabilizers are used. In some embodiments, the light absorbing pigment is selected from a least one UV absorber. In another embodiment, the light absorbing pigment is selected from at least one UV stabilizer. In yet another embodiment, mixtures of UV absorbers and UV stabilizers are used. In some embodiments, the light absorbing pigment is selected from a group consisting of carbon black, titanium dioxide, benzotriazoles, benzophenones, hindered amines and mixtures thereof.

There is a practical limit to the amount of light absorbing pigment that can be added. If the amount of pigment is too high then adhesion, electrical insulating ability and mechanical properties can be adversely affected.

### Heat sink

The metal heat sink absorbs and dissipates thermal energy or heat. Heat sinks are used in a wide range of applications wherever efficient heat dissipation is required. Heat sinks function by efficiently transferring thermal energy from an object at high temperature to a second object at a lower temperature with a much greater heat capacity. For purposes of this disclosure, the heat sink transfers heat or thermal energy from an electrical component. Efficient function of a heat sink relies on rapid transfer of thermal energy. The heat sinks are typically composed of thermally conducting materials such as aluminum, anodized aluminum or thermally conductive polymers. Their construction can be as simple as a metal plate to a metal device with many fins. The high thermal conductivity of the metal combined with its large surface area result in the rapid transfer of thermal energy to the surrounding, cooler, air. This cools the heat sink and whatever it is in direct thermal contact with.

As used herein, the terms "comprises," "comprising," "includes," "including," "has," "having" or any other variation thereof, are intended to cover a non-exclusive inclusion. For example, a method, process, article, or apparatus that comprises a list of elements is not necessarily limited only those elements but may include other elements not expressly listed or inherent to such method, process, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the disclosure. This is done merely for convenience and to give a general sense of the disclosure. This description should be read to include one or at least one and the singular also includes the plural unless it is obvious that it is meant otherwise.

### EXAMPLES

The present disclosure will be further described in the following examples. Examples are not intended to limit the scope of this disclosure.

| | |
|---|---|
| Kapton® 200 CR | A multilayer aromatic polyimide film containing aluminum oxide, 50 microns (2 mil) thick, available from E. I. DuPont de Nemours and Company, Wilmington, DE. |
| Kapton® 100 MT | A multilayer aromatic polyimide film containing aluminum oxide, 25 microns (1 mil) thick, available from E. I. DuPont de Nemours and Company |

### Example 1

Example 1 illustrates the use of a Kapton® 200 CR polyimide film and a formulated ethylene vinyl acetate (EVA) copolymer adhesive. A 50 micron (2 mil) Kapton® 200 CR film is coated with an aqueous dispersion of tetrafluoroethylene hexafluoropropylene which is subsequently dried and cured to a fluoropolymer film of about 2.5 micron (0.1 mil) thickness. Two of these fluoropolymer coated polyimide films are subsequently laminated together with the fluoropolymer layers facing each other to yield a multilayer film of about 105 microns (4.2 mil) total thickness. Onto this composite film, a formulated ethylene vinyl acetate (EVA) copolymer is extrusion coated to a thickness of about 25 microns (1 mil) to 75 microns (3 mil). The formulated EVA contains an organic peroxide such as TBEC, a UV absorber of the benzotriazole type, a hindered amine light stabilizer, primary and secondary antioxidants, an organo functional silane adhesion promoter. Bonding results between the adhesive and the polyimide film are shown in table 1. This adhesive coated polyimide film was subsequently laminated to an aluminum plate and the EVA copolymer layer cured to yield an electrically insulating, thermally conductive device for which the bonding results of the composite film to the aluminum plate are shown in table 1. Results for subjecting this device to water soaking at ambient temperature for greater than 12 days is shown in table 2. In combination with the aluminum heat sink, the Kapton CR based composite film is expected to provide excellent electrical insulation performance and very high dielectric breakdown strength while still allowing adequate thermal dissipation performance.

### Example 2

Example 2 illustrates the use of a Kapton® 200 CR polyimide film and a ethylene n-butylacrylate glycidyl methacrylate (EnBAGMA) terpolymer adhesive.
The sample is prepared in a similar manner to example 1.
Results are shown in tables 1 and 2.

### Example 3

Example 3 illustrates the use of a Kapton® 200 CR polyimide film and an ethylene methacrylic acid (EMAA) copolymer adhesive.
The sample is prepared in a similar manner to example 1.
Results are shown in tables 1 and 2.

### Example 4

Example 4 illustrates the use of a Kapton® 100 MT polyimide film and a formulated ethylene vinyl acetate (EVA) copolymer adhesive. A formulated ethylene vinyl acetate (EVA) copolymer is extrusion coated onto Kapton® 100 MT polyimide film to produce a polyimide composite film. The Kapton MT would be expected to provide higher thermal dissipation performance vs. the equivalent construction based on Kapton CR, while still providing adequate electrical insulation performance.
The sample is prepared in a similar manner to example 1.
Results are shown in tables 1 and 2.

### Example 5

Example 5 illustrates the use of a Kapton® 100 MT polyimide film and an ethylene n-butylacrylate glycidyl methacrylate (EnBAGMA) terpolymer adhesive.
The sample is prepared in a similar manner to example 1.
Results are shown in tables 1 and 2.

### Example 6

Example 6 illustrates the use of a Kapton® 100 MT polyimide film and an ethylene methacrylic acid (EMAA) copolymer adhesive.
The sample is prepared in a similar manner to example 1.
Results are shown in tables 1 and 2.

### Comparative example 1

Comparative example 1 illustrates the use of a Kapton® 200 CR polyimide film and an ethylene vinyl acetate (EVA) copolymer adhesive.
The sample is prepared in a similar manner to example 1.
Results are shown in tables 1 and 2.

### Comparative example 2

Comparative example 2 illustrates the use of a Kapton® 100 MT polyimide film and an ethylene vinyl acetate (EVA) copolymer adhesive.
The sample is prepared in a similar manner to example 1.
Results are shown in tables 1 and 2.

### Comparative example 3

Comparative example 3 illustrates the use of a Kapton® 200 CR polyimide film and an ethylene methacrylate (EMA) copolymer adhesive.
The sample is prepared in a similar manner to example 1.
Results are shown in tables 1 and 2.

### Comparative example 4

Comparative example 4 illustrates the use of a Kapton® 100 MT polyimide film and an ethylene methacrylate (EMA) copolymer adhesive. The sample is prepared in a similar manner to example 1.
Results are shown in tables 1 and 2.

The test results for adhesion for initial adhesion and adhesion after soaking are shown below.
Excellent means could not be separated without tearing.
Peelable means could be peeled but good adhesion.
Poor means unacceptable adhesion.

**Table 1 Initial Adhesion**

| | Kapton® 200 CR | Kapton® 100 MT | Aluminum sheeting | Photovoltaic cell |
|---|---|---|---|---|
| Example 1 Formulated EVA | excellent | | excellent | excellent |
| Example 2 EnBAGMA | excellent | | excellent | excellent |
| Example 3 EMAA | excellent | | excellent | excellent |
| Example 4 Formulated EVA | | excellent | excellent | excellent |
| Example 5 EnBAGMA | | excellent | excellent | excellent |
| Example 6 EMAA | | excellent | excellent | excellent |
| | | | | |
| Comparative example 1 EVA | excellent | | peelable | |
| Comparative example 2 EVA | | excellent | peelable | |
| Comparative example 3 EMA | excellent | | peelable | |
| Comparative example 4 EMA | | excellent | peelable | |

**Table 2 Adhesion after soaking at ambient temperature for greater than 12 days**

| | Kapton® 200 CR | Kapton® 100 MT | Aluminum sheeting | Photovoltaic cell |
|---|---|---|---|---|
| Example 1 Formulated EVA | excellent | | peelable | excellent |
| Example 2 EnBAGMA | excellent | | excellent | excellent |
| Example 3 EMAA | excellent | | excellent | excellent |
| Example 4 Formulated EVA | | excellent | peelable | excellent |
| Example 5 EnBAGMA | | excellent | excellent | excellent |
| Example 6 EMAA | | excellent | excellent | excellent |
| | | | | |
| Comparative example 1 EVA | excellent | | poor | |
| Comparative example 2 EVA | | excellent | poor | |
| Comparative example 3 EMA | excellent | | poor | |
| Comparative example 4 EMA | | excellent | poor | |

Note that not all of the activities described above in the general description or the examples are required, that a portion of a specific activity may not be required, and that further activities may be performed in addition to those described. Still further, the order in which each of the activities are listed are not necessarily the order in which they are performed. After reading this specification, skilled artisans will be capable of determining what activities can be used for their specific needs or desires.

In the foregoing specification, the invention has been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense and all such modifications are intended to be included within the scope of the invention.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims.

When an amount, concentration, or other value or parameter is given as either a range, preferred range or a list of upper values and lower values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

## Claims

1. A device for thermally cooling while electrically insulating comprising:
A. a first adhesive layer having a top surface and a bottom surface, the first adhesive layer bottom surface being directly bonded to a polyimide substrate, the first adhesive layer comprising an amount from 68 to 98 weight percent vinyl or acrylic polymer;
B. a polyimide substrate comprising at least a first polyimide layer and a second polyimide layer wherein:
i. the first polyimide layer and the second polyimide layer are directly bonded to each other; the first polyimide layer and the second polyimide layer are the same or different, and provide thermal conduction and electrical insulation properties,
ii. the first polyimide layer and the second polyimide layer each comprise an amount from 40 to 90 weight percent polyimide, the polyimide being derived from at least one aromatic dianhydride and at least one aromatic diamine, the aromatic diamine being at least 80 mole percent of the total moles of diamine incorporated into the polyimide and the aromatic dianhydride being at least 80 mole percent of the total moles of dianhydride incorporated into the polyimide, and
iii. the first polyimide layer and the second polyimide layer each further comprise 10 to 50 weight percent thermally conductive filler, and 0 to 20 weight percent light absorbing pigment;
C. a second adhesive layer having a top surface and a bottom surface, the second adhesive layer top surface being directly bonded to the polyimide substrate; the second adhesive layer comprising an amount from 68 to 98 weight percent vinyl or acrylic polymer
D. a metal heat sink having a top surface and a bottom surface, the heat sink top surface being directly bonded to the second adhesive layer bottom surface.

2. A device in accordance with claim 1, wherein the first adhesive layer and the second adhesive layer additionally comprise a filler selected from thermally conductive filler, light absorbing pigment and mixtures thereof.

3. A device in accordance with claim 1 or 2, wherein the first adhesive layer and second adhesive layers are selected from a group consisting of:
ethylene vinyl acetate copolymer with adhesion promotor,
ethylene vinyl acetate glycidyl acrylate terpolymer,
ethylene vinyl acetate glycidyl methacrylate terpolymer,
ethylene alkyl acrylate copolymers with adhesion promotor,
ethylene alkyl methacrylate copolymers with adhesion promotor,
ethylene glycidyl acrylate,
ethylene glycidyl methacrylate,
ethylene alkyl acrylate glycidyl acrylate terpolymer,
ethylene alkyl methacrylate glycidyl acrylate terpolymer,
ethylene alkyl acrylate maleic anhydride terpolymers,
ethylene alkyl methacrylate maleic anhydride terpolymers
ethylene alkyl acrylate glycidyl methacrylate terpolymers,
ethylene alkyl methacrylate glycidyl methacrylate terpolymers,
alkyl acrylate acrylonitrile acrylic acid terpolymers,
alkyl acrylate acrylonitrile methacrylic acid terpolymers,
ethylene acrylic acid copolymer including salts thereof,
ethylene methacrylic acid copolymer including salts thereof,
alkyl acrylate acrylonitrile glycidyl methacrylate terpolymers,
alkyl methacrylate acrylonitrile glycidyl methacrylate terpolymers,
alkyl acrylate acrylonitrile glycidyl acrylate terpolymers,
alkyl methacrylate acrylonitrile glycidyl acrylate terpolymers,
polyvinyl butyral,
ethylene alkyl acrylate methacrylic acid terpolymers including salts thereof,
ethylene alkyl methacrylate methacrylic acid terpolymers including salts thereof,
ethylene alkyl acrylate acrylic acid terpolymers including salts thereof mixtures thereof,
ethylene alkyl methacrylate acrylic acid terpolymers including salts thereof,
ethylene ethyl hydrogen maleate,
ethylene alkyl acrylate ethyl hydrogen maleate,
ethylene alkyl methacrylate ethyl hydrogen maleate,
and mixtures thereof.

4. A device in accordance with claim 1, wherein the polyimide substrate additionally comprises at least one fluoropolymer adhesive layer having a top layer and a bottom layer wherein the fluoropolymer adhesive top layer is attached to the first polyimide layer and the fluoropolymer adhesive bottom layer is attached to the second polyimide layer.

5. A device in accordance with claim 4, wherein the fluoropolymer adhesive layer is selected from tetrafluoroethylene hexafluoropropylene copolymer, tetrafluoroethylene perfluoroalkoxy copolymer, tetrafluoroethylene ethylene copolymer, polyvinyl fluoride and mixtures thereof.

6. A device in accordance with claim 4, wherein the fluoropolymer adhesive layer additionally comprises a thermally conductive filler.

7. A device in accordance with claim 4, wherein the polyimide substrate first polyimide layer and second polyimide layer comprise two or more polyimide layers.

8. A device in accordance with claim 1, wherein the aromatic dianhydride is selected from a group consisting of pyromellitic dianhydride (PMDA), 3,3',4,4'-biphenyl tetracarboxylic dianhydride (BPDA), 3,3',4,4'-benzophenone tetracarboxylic dianhydride (BTDA); 4,4'-oxydiphthalic anhydride (ODPA), 3,3',4,4'-diphenyl sulfone tetracarboxylic dianhydride (DSDA), 2,2-bis(3,4-dicarboxyphenyl) 1,1,1,3,3,3-hexafluoropropane dianhydride (6FDA) and mixtures thereof; and
wherein the aromatic diamine is selected from a group consisting of 3,4'-diaminodiphenyl ether (3,4'-ODA), 1,3-bis-(4-aminophenoxy) benzene (APB-134 or RODA), 4,4'-diaminodiphenyl ether (4,4'-ODA), 1,4-diaminobenzene (PPD), 1,3-diaminobenzene (MPD) and mixtures thereof.

9. A device in accordance with claims 1, 2 or 6 wherein the thermally conductive filler is selected from a group consisting of aluminum oxide, boron nitride coated aluminum oxide, granular aluminum oxide, fumed aluminum oxide, silicon dioxide, granular silicon dioxide, fumed silicon dioxide, silicon carbide, aluminum nitride, aluminum oxide coated aluminum nitride, silicon dioxide coated aluminum nitride, titanium dioxide, boron nitride, cubic boron nitride, hexagonal boron nitride, diamond, beryllium oxide, talc, zinc oxide and mixtures thereof.

10. A device in accordance with claims 1 or 2, wherein the light absorbing pigment is selected from a group consisting of carbon black, titanium dioxide, benzotriazoles, benzophenones, hindered amines and mixtures thereof.

11. A device in accordance with claim 1 wherein the first adhesive layer and the second adhesive layer thickness are each from 6.25 to 75 microns.

12. A device in accordance with claim 1 wherein the polyimide substrate thickness is from 12.5 to 125 microns.

13. A device in accordance with claim 4 wherein the fluoropolymer adhesive layer thickness is from 1.25 to 12.5 microns.

14. A device in accordance with claim 1 further comprising photovoltaic cell directly bonded to the first adhesive layer top surface.
